# EUROPEAN PATENT APPLICATION

(11) **EP 4 753 382 A1**
(43) Date of publication of application: **03.06.2026**
(21) Application number: 24845239.3
(22) Date of filing: 13.06.2024
(51) Int. Cl.: H05K 3/20

(54) **METHOD FOR MANUFACTURING CIRCUIT PATTERN ASSEMBLY WITH RELEASE FILM, METHOD FOR MANUFACTURING CIRCUIT BOARD, AND CIRCUIT PATTERN ASSEMBLY WITH RELEASE FILM**

(30) Priority: 26.07.2023 JP 2023121541
(71) Applicant: NHK Spring Co., Ltd., Yokohama-shi, Kanagawa 236-0004 (JP)
(72) Inventor: YANO, Shinya, Yokohama-shi, Kanagawa 236-0004 (JP)
(74) Representative: TBK
(86) International application number: PCT/JP2024/021541
(87) International publication number: WO 2025/022857

(57) **Abstract**

Provided is a method for producing a release film-attached circuit-pattern aggregate that enables prevention of a defect due to etching from a front face.

Provided is a method for producing a release film-attached circuit-pattern aggregate, a circuit-pattern aggregate (2) including a dummy pattern (4) disposed in a gap (G) located between a plurality of circuit patterns (3) and a first gap (G1) located between the dummy pattern (4) and each circuit pattern (3), the method including: a step of providing, to a back face of a metal plate (9), a first back-face recess (G1R) corresponding to the first gap (G1) and a second back-face recess (G2R) corresponding to a second gap (G2) located between conductive patterns (3a); a step of applying a release film (5) to adhere to the back face of the metal plate (9) provided with the first back-face recess (G1R) and the second back-face recess (G2R); and a step of removing, by etching, a first portion corresponding to the first back-face recess (G1R) and a second portion corresponding to the second back-face recess (G2R) on a front face of the metal plate (9).

## Description

### Technical Field

The present invention relates to a method for producing a release film-attached circuit-pattern aggregate, a method for producing a circuit board, and a release film-attached circuit-pattern aggregate.

### Background Art

Conventionally, various types of circuit boards have been used. For example, Patent Literature 1 discloses a method for producing a circuit board for use in mounting of an electronic component for a power module or the like.

According to the method in Patent Literature 1, a metal plate is bonded to a ceramic substrate, a circuit pattern of resist is printed on the metal plate, and an unnecessary part is removed by etching to form a circuit pattern. After that, plating is applied to the front face of the circuit pattern to form a circuit board.

On the other hand, since an electronic component in a power module generates a large amount of heat, for enhanced heat dissipation, a circuit board in which a circuit pattern is stacked on a metallic base substrate, such as a heatsink, through an insulating layer has been studied. In addition, the demand for high-current power modules has been increasing in recent years, and also the demand for development of a circuit pattern having a thickness exceeding 0.5 mm has been increasing.

Patent Literature 2 discloses a technique in which electrolytic metal foil is detachably provided to a transfer sheet (release sheet), the electrolytic metal foil is etched to form a circuit pattern, the formed circuit pattern is applied to adhere to a target, and the transfer sheet is detached to transfer the circuit pattern to the target. Patent Literature 3 discloses a technique enabling formation of a circuit pattern thick in thickness due to etching of a metal plate from both its front face and back face. Therefore, use of such techniques may enable obtainment of such a circuit board as above.

### Citation List

### Patent Literatures

Patent Literature 1: JP 3795354 B2
Patent Literature 2: JP 2572071 B2
Patent Literature 3: JP H10-178256 A

### Summary of Invention

### Technical Problem

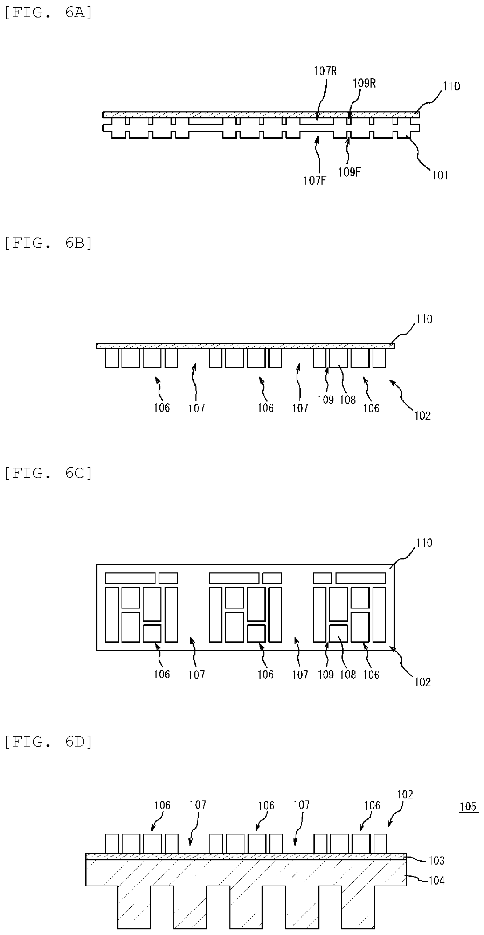

In some circuit boards, a plurality of circuit patterns is disposed on one base substrate and each circuit pattern enables achievement of a predetermined function with electronic components mounted. In this case, a relatively large gap (for example, approximately 10 mm) is generally provided between each adjacent circuit pattern. In transferring a circuit-pattern aggregate including a plurality of circuit patterns to a base substrate using such techniques as in Patent Literature 2 and Patent Literature 3, a defect was recognized at the time of etching. This point will be described, for example, with reference to Fig. 6A.

A metal plate 101 illustrated in Fig. 6A is finally formed as a circuit-pattern aggregate 102 (including three circuit patterns 106 in the present embodiment) illustrated in Figs. 6B and 6C. Fig. 6A is a side view illustrating the metal plate 101 laterally. Fig. 6B is a side view illustrating the circuit-pattern aggregate 102, formed from the metal plate 101, laterally, and Fig. 6C is a bottom view illustrating the circuit-pattern aggregate 102 in Fig. 6B from below. As illustrated in Fig. 6D, the circuit-pattern aggregate 102 is stacked on a base substrate 104, such as a heatsink, through an insulating layer 103, resulting in a circuit board 105. The illustrated circuit-pattern aggregate 102 includes a plurality of circuit patterns 106 (three in the present embodiment), and a gap 107 is provided between each adjacent circuit pattern 106. Each circuit pattern 106 includes a plurality of conductive patterns 108, and a second gap 109 is provided between each conductive pattern 108.

The metal plate 101 illustrated in Fig. 6A has a front face (lower face in Fig. 6A) and a back face (upper face in Fig. 6A) that are provided with recesses, for example, due to etching. Among the illustrated recesses, wide recesses (each recess on the back face is referred to as a back-face recess 107R and each recess on the front face is referred to as a front-face recess 107F) each finally result in the corresponding gap 107, and narrow recesses (each recess on the back face is referred to as a second back-face recess 109R and each recess on the front face is referred to as a second front-face recess 109F) each finally result in the corresponding second gap 109.

Then, as illustrated, with the metal plate 101 having its back face to which a release film 110 adheres, etching is performed on the front face of the metal plate 101. In order to apply the release film 110 to adhere to the back face of the metal plate 101, in general, a laminator is used in consideration of mass productivity, for example. The laminator includes a circular roller that presses the release film 110 long in shape against the back face of the metal plate 101, and feeds the release film 110 and the metal plate 101 with the release film 110 adhering to the metal plate 101 due to rotation of the roller. Note that, although not illustrated, the parts out of the front-face recesses 107F and the second front-face recesses 109F on the front face of the metal plate 101 are covered with a cured dry film obtained due to an exposure step before etching. Then, for example, when etching is performed by a device that sprays an etching solution to the front face of the metal plate 101, the part (front-face recesses 107F and second front-face recesses 109F) out of the parts covered with the cured dry film is dissolved in its thickness direction, and thus each front-face recess 107F and the corresponding back-face recess 107R are connected together and each second front-face recess 109F and the corresponding second back-face recess 109R are connected together, forming the circuit-pattern aggregate 102 illustrated in Fig. 6B.

Note that, with the circuit-pattern aggregate 102, illustrated in Figs. 6B and 6C, having its back face to which the release film 110 adheres, a transfer object, not illustrated, is pressed against the front face of the circuit-pattern aggregate 102 such that the circuit-pattern aggregate 102 is transferred to the transfer object. After that, the release film 110 is detached from the circuit-pattern aggregate 102 transferred to the transfer object, and then the circuit-pattern aggregate 102 is transferred from the transfer object to the insulating layer 103 stacked on the base substrate 104, resulting in the circuit board 105 illustrated in Fig. 6D.

However, due to etching with the above-described metal plate 101 having its back face to which the release film 110 adheres, part of the back face of each circuit pattern 106 adjacent to the corresponding gap 107 was dissolved. Due to occurrence of such dissolution, the circuit patterns 106 are not necessarily favorably bonded to the insulating layer 103.

In consideration of such a problem, an object of the present invention is to provide a method for producing a release film-attached circuit-pattern aggregate having its back face to which a release film adheres, the method enabling prevention of a defect due to etching from a front face. In addition, a method for producing a circuit board and a release film-attached circuit-pattern aggregate are provided using techniques related to the method for producing a release film-attached circuit-pattern aggregate.

### Solution to Problem

According to the present invention, provided is a method for producing a circuit pattern, the method including: a step of applying plating to a predetermined part on a front face of a metal plate; a step of applying a release film to adhere to a back face of the metal plate to which the plating is applied; a step of providing, to the front face of the metal plate, a resist pattern that covers the plating; and a step of forming the circuit pattern adhering to the release film by etching the metal plate provided with the resist pattern.

According to the present invention, provided is a method for producing a circuit board including a base substrate, an insulating layer stacked on the base substrate, and the circuit pattern that is obtained by the above-described method and is stacked on the insulating layer, the method including: a step of transferring the circuit pattern to a transfer object; a step of detaching the release film from the circuit pattern; and a step of transferring the circuit pattern from the transfer object to the insulating layer.

According to the present invention, provided is a release film-attached circuit-pattern aggregate that is formed using a metal plate and has a back face to which a release film adheres, the circuit-pattern aggregate including: a plurality of circuit patterns each including conductive patterns; a dummy pattern disposed in a gap located between the plurality of circuit patterns; and a first gap located between the dummy pattern and each of the plurality of circuit patterns adjacent to the dummy pattern.

Preferably, the dummy pattern includes a portion extending outside the circuit-pattern aggregate.

Preferably, the gap located between the plurality of circuit patterns is larger than 2 mm, and the first gap is 0.8 mm or more and 3 mm or less.

### Advantageous Effects of Invention

According to the inventors' repeated studies, it is found that, because the gap located between adjacent circuit patterns is relatively large in general, in a case where a release film is applied to adhere to the back face provided with a back-face recess of a metal plate, the release film adheres while bending in the back-face recess and thus the release film does not adhere sufficiently near edges adjacent to the back-face recess of the metal plate. In a case where etching is performed from the front face in this state, an etching solution enters the gap between the metal plate and the release film in a stack near the edges adjacent to the back-face recess of the metal plate, resulting in dissolution of the back face of the metal plate.

On the other hand, in a method for producing a release film-attached circuit-pattern aggregate, a method for producing a circuit board, and a release film-attached circuit-pattern aggregate according to the present invention, a dummy pattern is disposed in a gap located between adjacent circuit patterns, and thus a release film adheres favorably over the entirety of the back face of a metal plate without bending in a back-face recess unlike the conventional case. Therefore, in a case where etching is performed on the release film-attached circuit-pattern aggregate having its back face to which the release film adheres from the front face thereof, a defect in which part of the back face of a circuit pattern is dissolved can be prevented.

### Brief Description of Drawings

Fig. 1A is a side view illustrating an embodiment of a release film-attached circuit-pattern aggregate according to the present invention.
Fig. 1B is a bottom view of the release film-attached circuit-pattern aggregate illustrated in Fig. 1A.
Fig. 1C is a side view of a circuit board using the release film-attached circuit-pattern aggregate of Fig. 1A.
Fig. 2A illustrates a method for producing the release film-attached circuit-pattern aggregate according to the present invention (step S1).
Fig. 2B illustrates the method for producing the release film-attached circuit-pattern aggregate according to the present invention (step S2).
Fig. 2C illustrates the method for producing the release film-attached circuit-pattern aggregate according to the present invention (step S3).
Fig. 2D illustrates the method for producing the release film-attached circuit-pattern aggregate according to the present invention (step S4).
Fig. 3A illustrates the method for producing the release film-attached circuit-pattern aggregate according to the present invention (step S5).
Fig. 3B illustrates the method for producing the release film-attached circuit-pattern aggregate according to the present invention (step S6).
Fig. 3C illustrates the method for producing the release film-attached circuit-pattern aggregate according to the present invention (step S9).
Fig. 4A illustrates a method for producing a circuit board according to the present invention (step S11).
Fig. 4B illustrates the method for producing a circuit board according to the present invention (step S12).
Fig. 4C illustrates the method for producing a circuit board according to the present invention (step S13).
Fig. 4D illustrates the method for producing a circuit board according to the present invention (step S14).
Fig. 5 is a flowchart of a method of producing circuit patterns and the method for producing a circuit board according to the present invention.
Fig. 6A is a side view of a metal plate based on Patent Literature 2 and Patent Literature 3.
Fig. 6B is a side view of a circuit-pattern aggregate formed from the metal plate of Fig. 6A.
Fig. 6C is a bottom view of the circuit-pattern aggregate illustrated in Fig. 6B.
Fig. 6D is a side view of a circuit board including the circuit-pattern aggregate of Fig. 6B.

### Description of Embodiments

Embodiments of a method for producing a release film-attached circuit-pattern aggregate, a method for producing a circuit board, and a release film-attached circuit-pattern aggregate according to the present invention will be described below with reference to the accompanying drawings. Note that the illustrations in the accompanying drawings are schematic and thus, for example, the thickness or width of each part and the ratio between each part may be different from the actual ones.

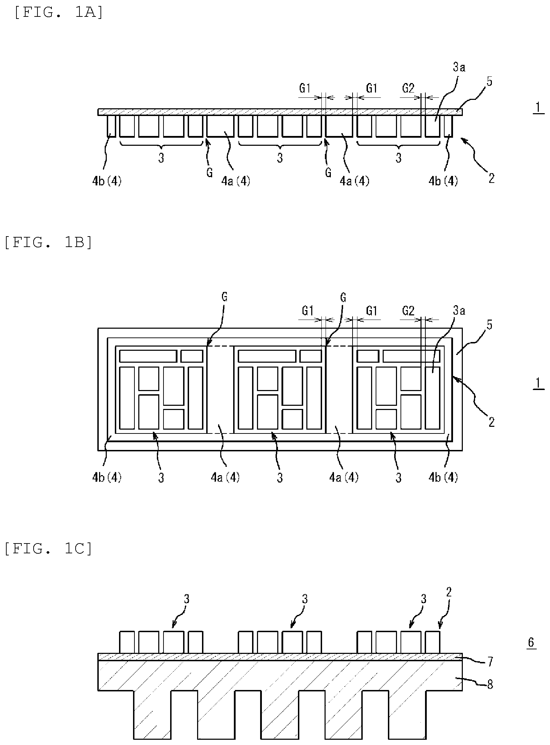

First, a release film-attached circuit-pattern aggregate as an exemplary product by a method for producing a release film-attached circuit-pattern aggregate in the present embodiment and a circuit board as an exemplary product by a method for producing a circuit board in the present embodiment will be described. A release film-attached circuit-pattern aggregate 1 illustrated in Figs. 1A and 1B includes a circuit-pattern aggregate 2 and a release film 5 adhering to the back face of the circuit-pattern aggregate 2. Note that, in the description of the present embodiment, the upper face of the circuit-pattern aggregate 2 illustrated in Fig. 1A is referred to as the back face of the circuit-pattern aggregate 2 and the lower face of the circuit-pattern aggregate 2 illustrated in Fig. 1A is referred to as the front face of the circuit-pattern aggregate 2.

The circuit-pattern aggregate 2 results from etching of a metal plate into a predetermined pattern as described later. The circuit-pattern aggregate 2 is formed by etching a relatively thick copper plate (rolled copper). As the thickness of the circuit-pattern aggregate 2 (thickness of thick copper), an appropriate thickness can be selected depending on the purpose, and a thickness in the range of 0.3 to 2.5 mm is selected in the present embodiment.

The circuit-pattern aggregate 2 in the present embodiment includes three circuit patterns 3 in total as illustrated. Note that the number of circuit patterns 3 in the present embodiment is exemplary and the number of circuit patterns 3 of the circuit-pattern aggregate 2 is required at least to be two or more. Each of the circuit patterns 3 achieves a predetermined function, for example, with electronic components mounted thereon. In the circuit-pattern aggregate 2 in the present embodiment, the three circuit patterns 3 are disposed side by side in a line, and the gap G between each adjacent circuit pattern 3 is provided with a dummy pattern 4 (in detail, a partition 4a extending such that the adjacent circuit patterns 3 are partitioned). The dummy pattern 4 in the present embodiment includes an outer portion 4b that is in connection with the partitions 4a and extends outside the circuit-pattern aggregate 2. The outer portion 4b in the present embodiment is formed in a rectangular frame as illustrated in Fig. 1B. Note that the dummy pattern 4 is separate from the circuit patterns 3 and is electrically independent of the circuit patterns 3. Then, the circuit patterns 3 each include a plurality of electrically independent conductive patterns 3a.

The gap located between the dummy pattern 4 and each circuit pattern 3 adjacent to the dummy pattern 4 is referred to as a first gap G1. The gap between each conductive pattern 3a is referred to as a second gap G2. As illustrated, the dummy pattern 4 is located between each adjacent first gap G1 (between each adjacent first gap G1 in the area free of the second gaps G2 between two first gaps G1). Note that the gaps G are wider in width than the second gaps G2. As an example, the gaps G are each 10 mm in width, the first gaps G1 are each 1 mm in width, and the second gaps G2 are each 1 mm in width. Then, the width of each first gap G1 is preferably 0.8 mm or more and 3 mm or less, more preferably, 0.8 mm or more and 2 mm or less, further preferably 0.8 mm or more and 1 mm or less as described later. Each second gap G2 is set preferably at 1mm or more and 3 mm or less, more preferably 1 mm or more and 2.5 mm or less, further preferably 1 mm or more and 2 mm or less. In a case where each second gap G2 exceeds 3 mm, like the dummy pattern 4, preferably, other dummy patterns electrically independent of the circuit patterns 3 are each disposed in the corresponding second gap G2 such that the second gap G2 is 1 mm or more and 3 mm or less. Then, the gaps G are not particularly limited, provided that the first gaps G1 can be set in any of the ranges. However, in a case where the gaps G are extremely small, the width of the dummy pattern 4 is also small, making the circuit-pattern aggregate 2 difficult to produce. Thus, the gaps G are larger than 2 mm, generally, 3 mm or more.

The release film 5 corresponds to a film capable of reducing its initial adhesive force, for example, due to thermal irradiation or ultraviolet irradiation. The release film 5 in the present embodiment serves as a UV film having a property in which its initial adhesive force reduces due to ultraviolet irradiation.

A method for producing a circuit board, which will be described later, is performed using the above-described release film-attached circuit-pattern aggregate 1, so that a circuit board 6 illustrated in Fig. 1C can be produced. The circuit board 6 in the present embodiment includes the above-described circuit-pattern aggregate 2, an insulating layer 7, and a base substrate 8 that are stacked in this order. Note that the method for producing a circuit board, which will be described later, is performed, so that the circuit board 6 is provided with the circuit-pattern aggregate 2 from which the dummy pattern 4 is removed.

The insulating layer 7 is formed of a material having an insulating property and serves to electrically insulate between the circuit-pattern aggregate 2 and the base substrate 8 and additionally serves to bond the circuit-pattern aggregate 2 and the base substrate 8 together. For electronic components for a power module or the like to be mounted on the circuit-pattern aggregate 2, preferably, the insulating layer 7 has high thermal resistance against heat generated from such electronic components and high thermal conductivity to transfer the heat to the base substrate 8. The insulating layer 7 may cover the entire front face of the base substrate 8 or part of the front face thereof.

Examples of the material of the insulating layer 7 include a resin composition containing a thermal curable resin. Examples of the thermal curable resin include an epoxy resin, a phenolic resin, a melamine resin, a urea formaldehyde resin, an unsaturated polyester resin, an alkyd resin, and a cyanate resin. As the thermal curable resin, one type of thermal curable resin may be used alone or two or more types of thermal curable resins may be used in combination. Examples of those contained in the resin composition other than the thermal curable resin include a curing agent. Such a curing agent is not particularly limited, provided that the curing agent is selected depending on the type of the thermal curable resin and reacts with the thermal curable resin. Examples of the curing agent in a case where an epoxy resin is used include an amine-based curing agent, an imidazole-based curing agent, and a phenol-based curing agent. The resin composition may contain a filler (inorganic filler). The filler is preferably high in insulating property and high in thermal conductivity and examples thereof include aluminum oxide, silica, aluminum nitride, boron nitride, silicon nitride, and magnesium oxide. The resin composition may further contain, for example, a curing accelerator, a stabilizer, an ion scavenger, and a solvent. In addition, the resin composition may contain a softness imparting material.

The base substrate 8 can be formed of various materials, but is preferably formed of a material high in thermal conductivity in particular and is preferably formed of a metal, such as copper, aluminum, or iron (single metal or alloy). The base substrate 8 in the present embodiment is formed of copper. The illustrated base substrate 8 is provided with fins in order to enhance the effect of dissipating heat outward but may be like a plate with no fins. The base substrate 8 is not limited to being formed of a single member and thus may be formed of a plurality of members in combination. The base substrate 8 may have a configuration for a further improvement in the effect of dissipating heat outward and may be, for example, a metal plate in which a vapor chamber or a heat pipe is embedded.

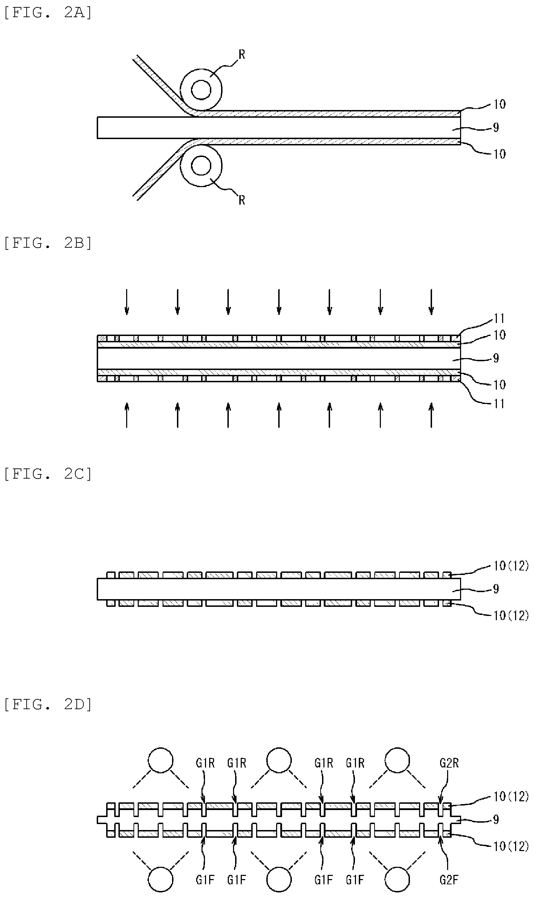

Next, the method for producing a release film-attached circuit-pattern aggregate and the method for producing a circuit board in the present embodiment will be described with reference to Figs. 2A to 5.

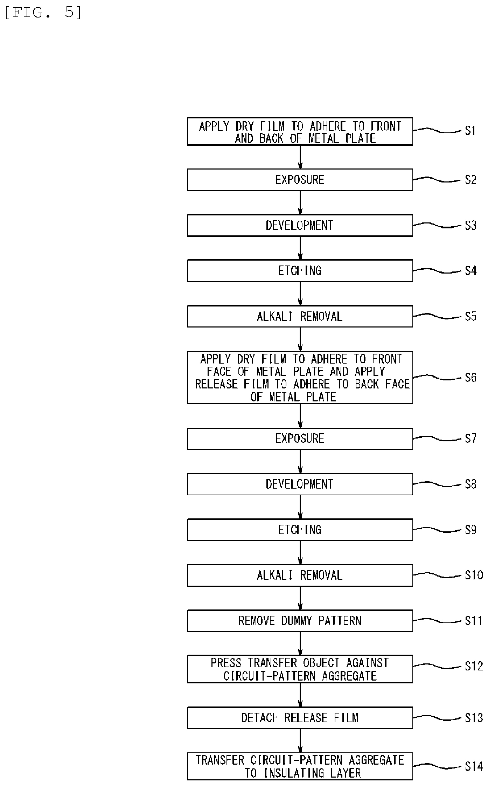

First, a dry film 10 is applied to adhere to both the front face and back face of a metal plate 9 illustrated in Fig. 2A (step S1 in Fig. 5). The metal plate 9 corresponds to a plate made of metal, such as aluminum or copper, and is a copper plate having a thickness of 0.5 to 2.0 mm as described above in the present embodiment. As an example, the dry film 10 has a thickness of approximately 25 to 150 µm. In order to apply the dry film 10 to adhere to the metal plate 9, preferably, a laminator including rollers R located one-to-one on the front-face side and back-face side of the metal plate 9 is used as illustrated in Fig. 2A. In the laminator, the dry film 10 is disposed on each of the front-face side and back-face side of the metal plate 9. Then, with the dry film 10 on the front-face side pressed against the front face of the metal plate 9 by the roller R on the front-face side and the dry film 10 on the back-face side pressed against the back face of the metal plate 9 by the roller R on the back-face side, the rollers R are rotated. Thus, the dry film 10 can adhere to the front face and back face of the metal plate 9.

Next, as illustrated in Fig. 2B, an exposure film 11 is disposed on each of the dry film 10 on the front-face side and the dry film 10 on the back-face side. The exposure films 11 each have openings at least at parts corresponding to the conductive patterns 3a in each circuit pattern 3 and at a part corresponding to the dummy pattern 4 illustrated in Fig. 1A (in other words, parts out of the parts corresponding to the first gaps G1 and the second gaps G2). Then, an exposure device irradiates the exposure films 11 with light to perform exposure (step S2 in Fig. 5). Due to the exposure, in each dry film 10, the parts directly below the openings of the corresponding exposure film 11 are cured by the light through the openings.

After that, for example, a developing device performs development to remove any uncured part, after the exposure, in each dry film 10 as illustrated in Fig. 2C (step S3 in Fig. 5). Thus, each of the front face and back face of the metal plate 9 has the parts cured due to the exposure in the corresponding dry film 10 at parts corresponding to the conductive patterns 3a in the circuit patterns 3 and at a part corresponding to the dummy pattern 4 illustrated in Fig. 1A (refer to Fig. 2C). Hereinafter, the dry film 10 remaining on the front face of the metal plate 9 after the development is referred to as a resist pattern 12. The resist pattern 12 has openings at parts corresponding to the first gaps G1 and the second gaps G2 illustrated in Fig. 1A.

After that, etching is performed on the metal plate 9 having the resist pattern 12 (step S4 in Fig. 5). In the present embodiment, double-sided etching is performed, in which etching is performed on the metal plate 9 from both its front-face side and back-face side (refer to Fig. 2D). For such double-sided etching, for example, an etching device that jets an etching solution to the metal plate 9 from both its front-face side and back-face side can be used (for example, refer to WO 2022/102357 A). Thus, the front face and back face of the metal plate 9 are dissolved in the thickness direction thereof at the parts at which the resist pattern 12 has the openings. In the double-sided etching, etching is performed until a certain degree of intermediate part is left in the thickness direction of the metal plate 9. Thus, the front face and back face of the metal plate 9 each have recesses at positions corresponding to the first gaps G1 and recesses at positions corresponding to the second gaps G2. Among the recesses at the positions corresponding to the first gaps G1, the recesses on the front face are each referred to as a first front-face recess G1F and the recesses on the back face are each referred to as a first back-face recess G1R. Among the recesses at the positions corresponding to the second gaps G2, the recesses on the front face are each referred to as a second front-face recess G2F and the recesses on the back face are each referred to as a second back-face recess G2R. Note that the partitions 4a of the dummy pattern 4 illustrated in Fig. 1A are located between the adjacent first front-face recesses G1F (between the adjacent first back-face recesses G1R).

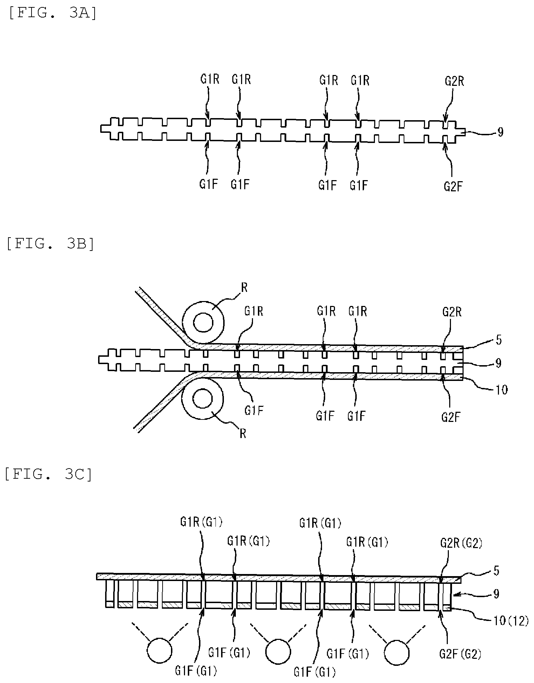

After that, an alkaline removal device removes the resist pattern 12 covering the front face and back face of the metal plate 9 using an alkaline solution (step S5 in Fig. 5). Thus, as illustrated in Fig. 3A, the metal plate 9 is formed having its front face provided with the first front-face recesses G1F and the second front-face recesses G2F and its back face provided with the first back-face recesses G1R and the second back-face recesses G2R.

Next, as illustrated in Fig. 3B, a dry film 10 is applied to adhere to the front face of the metal plate 9 and the release film 5 described with reference to Fig. 1A is applied to adhere to the back face of the metal plate 9 (step S6 in Fig. 5). In order to apply the dry film 10 and the release film 5 to adhere to the metal plate 9, preferably, such a laminator including rollers R located one-to-one on the front-face side and back-face side of the metal plate 9 as illustrated in Fig. 2A is used. Then, with the dry film 10 pressed against the front face of the metal plate 9 by the roller R on the front-face side and the release film 5 pressed against the back face of the metal plate 9 by the roller R on the back-face side, the rollers R are rotated, so that the dry film 10 can adhere to the front face of the metal plate 9 and the release film 5 can adhere to the back face of the metal plate 9. In a case where no dummy pattern is provided like the circuit-pattern aggregate 102 illustrated in Figs. 6B and 6C, at the time of adhesion of the release film 110 to the back face of the metal plate 101, the release film 5 adheres while bending in the back-face recesses 107R, so that the release film 5 may insufficiently adhere to the back face of the metal plate 9. On the other hand, in a case where the first back-face recesses G1R are provided for formation of the dummy pattern 4, a defect in which the release film 5 adheres while bending in can be prevented and thus the release film 5 can sufficiently adhere to the back face of the metal plate 9.

After that, similarly to the exposure step on the front-face side of the metal plate 9 illustrated in Fig. 2B, an exposure film 11 is disposed on the dry film 10 on the front-face side illustrated in Fig. 3B and then an exposure device irradiates the exposure film 11 with light to perform exposure (step S7 in Fig. 5). Note that illustration for step S7 is omitted. The exposure film 11 in the exposure step in step S7 is similar to the exposure film 11 in step S2. Therefore, due to the exposure in step S7, in the dry film 10 adhering to the front face of the metal plate 9, at least parts corresponding to the conductive patterns 3a in each circuit pattern 3 and a part corresponding to the dummy pattern 4 (in other words, parts out of the parts corresponding to the first gaps G1 and the second gaps G2) are cured, similarly to Fig. 2B.

After that, similarly to the development step on the front-face side of the metal plate 9 illustrated in Fig. 2C, development is performed to remove any uncured part, after the exposure, in the dry film 10 adhering to the front face of the metal plate 9 (step S8 in Fig. 5). Thus, similarly to Fig. 2B, the front face of the metal plate 9 has the parts cured due to the exposure in the dry film 10 at parts corresponding to the conductive patterns 3a in the circuit patterns 3 and at a part corresponding to the dummy pattern 4. Note that, although illustration for step S8 is omitted, in the development step in step S8, such a resist pattern 12 as illustrated in Fig. 2B is provided to the front face of the metal plate 9 after the development.

Next, as illustrated in Fig. 3C, etching is performed on the metal plate 9 having the resist pattern 12 from its front-face side (step S9 in Fig. 5). In the present embodiment, such an etching device as illustrated in Fig. 2B jets an etching solution only from the front-face side as illustrated in Fig. 3C. Thus, the front face of the metal plate 9 is dissolved in the thickness direction thereof at the parts at which the resist pattern 12 has the openings (the parts at which the first front-face recesses G1F and the second front-face recesses G2F are located). Therefore, each first front-face recess G1F and the corresponding first back-face recess G1R are connected together and each second front-face recess G2F and the corresponding second back-face recess G2R are connected together, so that the first gaps G1 and the second gaps G2 are formed on the metal plate 9. As described above, since the first back-face recesses G1R are provided for formation of the dummy pattern 4, the release film 5 sufficiently adheres to the back face of the metal plate 9, and thus a defect in which the etching solution jetted from the etching device enters between the release film 5 and the metal plate 9 can be prevented.

The width of each first gap G1 (namely, the width of each first front-face recess G1F and the width of each first back-face recess G1R) will be described in detail. According to the inventors' repeated studies, in a case where each first gap G1 was extremely small, the mass productivity at the time of etching and the workability at the time of removal of the dummy pattern 4 deteriorated. In a case where each first gap G1 was extremely large, the release film 5 did not necessarily sufficiently adhere around each first back-face recess G1R. On the other hand, in a case where the width of each first gap G1 was 0.8 mm or more and 3 mm or less, not only the above-described mass productivity and workability were favorable but also the adhesion of the release film 5 was favorable. Then, according to further studies, it is found that the width of each first gap G1 is more preferably 0.8 mm or more and 2 mm or less, further preferably, 0.8 mm or more and 1 mm or less.

After that, similarly to the alkaline removal step on the front-face side of the metal plate 9 illustrated in Fig. 2B, the resist pattern 12 covering the front face of the metal plate 9 illustrated in Fig. 3C is removed with an alkaline solution (step S10 in Fig. 5). Thus, the release film-attached circuit-pattern aggregate 1 including the circuit-pattern aggregate 2 having its back face to which the release film 5 adheres illustrated in Fig. 1A is formed.

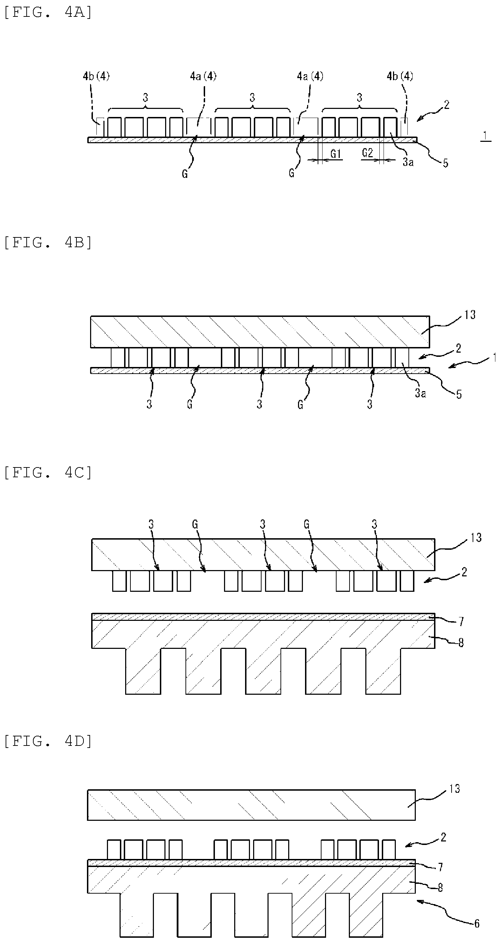

After the release film-attached circuit-pattern aggregate 1 is formed in this manner, as illustrated in Fig. 4A, the work of removing the dummy pattern 4 from the circuit-pattern aggregate 2 is performed (step S11 in Fig. 5). For removal of the dummy pattern 4, for example, a robot may lift up the dummy pattern 4 while grasping part of the dummy pattern 4 using its chuck and detach the dummy pattern 4 from the release film 5 or an operator may do such work, instead of the robot. The dummy pattern 4 in the present embodiment includes the outer portion 4b extending outside the circuit-pattern aggregate 2, and the outer portion 4b is graspable. Thus, a defect in which the array of the conductive patterns 3a in each circuit pattern 3 is disturbed at the time of removal of the dummy pattern 4 can be prevented. In particular, the outer portion 4b in the present embodiment is formed in a rectangular frame, and the outer portion 4b can be grasped by pinching the outer faces of facing sides among the four sides of the frame (for example, referring to Fig. 4A, the outer portion 4b can be grasped by pinching the right-side face of the outer portion 4b located on the right side and the left-side face of the outer portion 4b located on the left side). Thus, the work of removing the dummy pattern 4 can be easily performed.

After that, as illustrated in Fig. 4B, a step of pressing a transfer object 13 against the front face of the circuit-pattern aggregate 2 is performed (step S12 in Fig. 5). The transfer object 13 includes, for example, a cushion made of urethane having its front face provided with an adhesive layer and a backing plate stacked on the back face of the cushion. The face provided with the adhesive layer of the transfer object 13 is pressed against the front face of the circuit-pattern aggregate 2, so that the circuit-pattern aggregate 2 is held on the transfer object 13 due to adhesion.

Next, the release film 5 adhering to the back face of the circuit-pattern aggregate 2 is irradiated with ultraviolet rays to reduce the adhesive force of the release film 5, and the release film 5 is detached from the circuit-pattern aggregate 2 (step S13 in Fig. 5). That is, step S12 and step S13 are performed, so that the circuit-pattern aggregate 2 held on the release film 5 is transferred to the transfer object 13.

After that, as illustrated in Fig. 4C, the circuit-pattern aggregate 2 held on the transfer object 13 is pressed against an insulating layer 7 stacked on a base substrate 8 and then heating is performed. In the present embodiment, a vacuum press presses the transfer object 13 in a vacuum atmosphere at a predetermined temperature. Then, as illustrated in Fig. 4C, the transfer object 13 is detached after the insulating layer 7 is cured, so that the circuit-pattern aggregate 2 is transferred to the insulating layer 7 (step S14 in Fig. 5). Due to such steps, a circuit board 6 is completed.

Embodiments of the present invention have been described above, but the present invention is not limited to such particular embodiments. Unless otherwise particularly limited in the above description, various modifications and alterations can be made without departing from the scope of the gist of the present invention described in the claims. For example, the configurations of the above-described embodiments can be subjected to addition or deletion as appropriate, and the configuration of an embodiment can be provided to another embodiment. The effects in the above embodiments are merely exemplified as effects due to the present invention and thus do not mean that effects according to the present invention are limited to the above effects.

For example, preferably, the dummy pattern 4 includes a portion extending outside the circuit-pattern aggregate 2 like the outer portion 4b described above, but may include only the partitions 4a. The outer portion 4b is not limited to being formed in a rectangular frame described above. For example, the outer portion 4b may include only one long side in connection with the partitions 4a among two long sides and two short sides of the outer portion 4b illustrated in Fig. 1B. The work of removing the dummy pattern 4 illustrated in Fig. 4A may be performed after the circuit-pattern aggregate 2 is transferred to the transfer object 13 and then the release film 5 is detached as illustrated in Fig. 4C. In the above-described embodiments, the first front-face recesses G1F and the second front-face recesses G2F are provided on the front face of the metal plate 9 for etching on the metal plate 9 having its back face to which the release film 5 adheres, from the front-face side, as illustrated in Fig. 3C. However, the present invention includes a case where a metal plate 9 without such recesses as the first front-face recesses G1F or second front-face recesses G2F is used.

### Reference Signs List

- 1: release film-attached circuit-pattern aggregate
- 2: circuit-pattern aggregate
- 3: circuit pattern
- 3a: conductive pattern
- 4: dummy pattern
- 5: release film
- 6: circuit board
- 7: insulating layer
- 8: base substrate
- 9: metal plate
- G: gap
- G1: first gap
- G1R: first back-face recess
- G2: second gap
- G2R: second back-face recess

## Claims

1. A method for producing a release film-attached circuit-pattern aggregate that is formed using a metal plate and has a back face to which a release film adheres, the circuit-pattern aggregate including a plurality of circuit patterns each including conductive patterns, a dummy pattern disposed in a gap located between the plurality of circuit patterns, and a first gap located between the dummy pattern and each of the plurality of circuit patterns adjacent to the dummy pattern, the method comprising:
a step of providing, to a back face of the metal plate, a first back-face recess corresponding to the first gap and a second back-face recess corresponding to a second gap located between the conductive patterns;
a step of applying the release film to adhere to the back face of the metal plate provided with the first back-face recess and the second back-face recess; and
a step of removing, by etching, a first portion corresponding to the first back-face recess and a second portion corresponding to the second back-face recess on a front face of the metal plate.

2. A method for producing a circuit board including a base substrate, an insulating layer stacked on the base substrate, and the circuit-pattern aggregate that is obtained by the method according to claim 1 and is stacked on the insulating layer, the method comprising:
a step of transferring the circuit-pattern aggregate to a transfer object;
a step of detaching the release film from the circuit-pattern aggregate transferred;
a step of removing the dummy pattern from the circuit-pattern aggregate before the circuit-pattern aggregate is transferred to the transfer object or after the release film is detached from the circuit-pattern aggregate; and
a step of transferring, from the transfer object to the insulating layer, the circuit-pattern aggregate from which the dummy pattern is removed.

3. A release film-attached circuit-pattern aggregate that is formed using a metal plate and has a back face to which a release film adheres,
the circuit-pattern aggregate comprising:
a plurality of circuit patterns each including conductive patterns;
a dummy pattern disposed in a gap located between the plurality of circuit patterns; and
a first gap located between the dummy pattern and each of the plurality of circuit patterns adjacent to the dummy pattern.

4. The release film-attached circuit-pattern aggregate according to claim 3, wherein the dummy pattern includes a portion extending outside the circuit-pattern aggregate.

5. The release film-attached circuit-pattern aggregate according to claim 3, wherein the gap located between the plurality of circuit patterns is larger than 2 mm and the first gap is 0.8 mm or more and 3 mm or less.
